# FASCICULE DE BREVET EUROPEEN

(11) **EP 4 284 021 B1**
(45) Date de publication et mention de la délivrance du brevet: **26.03.2025**
(21) Numéro de dépôt: 23175579.4
(22) Date de dépôt: 26.05.2023
(51) Int. Cl.: H04R 19/00, H04R 31/00, B81B 3/00, G01H 11/06, H04R 1/02, H04R 19/04

(54) **TRANSDUCTEUR ÉLECTROACOUSTIQUE À FAIBLE BRUIT ET PROCÉDÉ DE FABRICATION**
ELEKTROAKUSTISCHER WANDLER MIT GERINGEM RAUSCHEN UND HERSTELLUNGSVERFAHREN
LOW NOISE ELECTROACOUSTIC TRANSDUCER AND METHOD OF MANUFACTURE

(30) Priorité: 27.05.2022 FR 2205088
(43) Date de publication de la demande: 29.11.2023
(73) Titulaire: Commissariat à l'Energie Atomique et aux Energies Alternatives, 75015 Paris (FR)
(72) Inventeur: DAGHER, Samer, 38054 GRENOBLE CEDEX 09 (FR); JOET, Loïc, 38054 GRENOBLE CEDEX 09 (FR)
(74) Mandataire: Cabinet Camus Lebkiri

(56) Documents cités:
- EP-A1- 3 975 584
- CN-A- 113 998 663
- US-A1- 2017 325 012
- YAO RUI ET AL: "A Micro-Insulation Concept for MEMS Applications", vol. 131, no. 5, 1 May 2009 (2009-05-01), US, XP093012674, ISSN: 0022-1481, Retrieved from the Internet <URL:https://blanchard.engr.wisc.edu/res/JHRBlanchard.pdf> DOI: 10.1115/1.3084121

## Description

### DOMAINE TECHNIQUE DE L'INVENTION

Le domaine technique de l'invention est celui des dispositifs de type microsystèmes électromécaniques (MEMS, pour « microelectromechanical systems » en anglais) ou nanosystèmes électromécaniques (NEMS, pour « nanoelectromechanical systems »). L'invention concerne plus particulièrement un transducteur électroacoustique comprenant un élément mobile et un volume arrière, le volume arrière étant délimité en partie par l'élément mobile et soumis à une pression de référence. Un tel transducteur électroacoustique peut être employé en tant que microphone ou haut-parleur.

### ARRIERE-PLAN TECHNOLOGIQUE DE L'INVENTION

Les microphones en microélectromécanique ou nanoélectromécanique représentent un marché en pleine expansion, notamment grâce au développement des appareils nomades, tels que les tablettes, téléphones portables intelligents (smartphones) et aux autres objets connectés, dans lesquels ils remplacent peu à peu les microphones à électret.

Les microphones mesurent une variation rapide de la pression atmosphérique, aussi appelée pression acoustique. Ils comportent donc au moins une partie en contact avec l'extérieur.

La plupart des microphones MEMS ou NEMS fabriqués actuellement sont des microphones à détection capacitive. Les demandes de brevet FR3059659A1 et EP3975584A1 décrivent un exemple de microphone à détection capacitive comprenant un élément mobile, des moyens de détection capacitive et un dispositif de transmission d'un mouvement entre l'élément mobile et les moyens de détection capacitive.

L'élément mobile est capable de récolter la variation de pression. Il peut être formé par un piston rigide comprenant une membrane et une structure de rigidification de la membrane. La membrane forme une séparation entre une cavité ouverte sur l'environnement extérieur et un volume arrière du microphone, aussi appelé volume de référence car il y règne une pression de référence. Ainsi, une face de la membrane est soumise à la pression de référence et une face opposée de la membrane est soumise à la pression atmosphérique (dont on souhaite détecter la variation). Le volume arrière est généralement connecté à l'environnement extérieur par un étroit chemin acoustique. La pression de référence est alors égale à la pression atmosphérique filtrée de ses composantes dynamique (à hautes fréquences) qui n'ont pas le temps de s'équilibrer. La différence de pression entre les deux faces de la membrane ne correspond alors plus qu'à ces variations hautes fréquences (le son), la pression atmosphérique et ses variations lentes étant annulées.

Ce microphone à détection capacitive, comme les autres transducteurs électroacoustiques munis d'une membrane et d'un volume arrière, souffre de bruit acoustique. Ce bruit acoustique s'ajoute au signal utile en sortie du microphone et détériore ses performances.

Le document US2017/325012A1 décrit un autre transducteur électroacoustique comprenant un bâti, un élément mobile par rapport au bâti et une cavité interne délimitée par l'élément mobile et des parois appartenant au bâti. Le bâti est composé d'un substrat et d'un couvercle. Une surface intérieure du couvercle est composée d'un matériau isolant thermiquement, afin de réduire la fréquence des fluctuations de pression du gaz à l'intérieur de la cavité interne, et donc diminuer le bruit.

### RESUME DE L'INVENTION

Il existe donc un besoin de prévoir un transducteur électroacoustique dans lequel le bruit acoustique est réduit.

Selon un premier aspect de l'invention, on tend à satisfaire ce besoin en prévoyant un transducteur électroacoustique comprenant :
- un bâti comprenant un support, une première portion d'une première couche structurelle disposée sur le support et un capot disposé sur la première portion de la première couche structurelle, la première couche structurelle présentant une épaisseur inférieure à 2 µm ;
- un élément mobile par rapport au bâti, l'élément mobile comprenant une membrane ;
- une cavité interne appelée volume arrière, soumise à une pression de référence et délimitée par l'élément mobile et des première et deuxième parois appartenant au bâti, la première paroi étant située dans le prolongement de la membrane et la deuxième paroi étant disposée en regard de la membrane.

La première paroi comprend au moins une cavité étanche séparée du volume arrière par la première portion de la première couche structurelle et une pression inférieure à la pression de référence règne dans ladite au moins une cavité étanche de la première paroi.

La cavité étanche réduit les échanges thermiques entre le volume arrière et ses frontières, ce qui a pour effet de réduire le bruit acoustique associé (à volume arrière constant). Cela permet alternativement de réduire le volume arrière, et donc l'encombrement du microphone, à performances équivalentes.

De préférence, la membrane est formée par une deuxième portion de la première couche structurelle.

Dans un mode de réalisation, la deuxième paroi comprend au moins une cavité étanche, une pression inférieure à la pression de référence règne dans ladite au moins une cavité étanche de la deuxième paroi et ladite au moins une cavité étanche de la deuxième paroi est située dans le capot et séparée du volume arrière par une troisième couche structurelle d'épaisseur inférieure à 2 µm.

Outre les caractéristiques qui viennent d'être évoquées dans les paragraphes précédents, le transducteur électroacoustique selon l'invention peut présenter une ou plusieurs caractéristiques complémentaires parmi les suivantes, considérées individuellement ou selon toutes les combinaisons techniquement possibles :
- la pression dans ladite au moins une cavité étanche est inférieure ou égale à 1000 Pa (10 mbar), de préférence inférieure ou égale à 100 Pa (1 mbar) ;
- au moins une des première et deuxièmes parois délimitant le volume arrière comprend une unique cavité étanche, l'unique cavité étanche comprenant des piliers de largeur comprise entre 500 nm et 50 µm ;
- au moins une des première et deuxièmes parois délimitant le volume arrière comprend plusieurs cavités étanches séparées entre elles par des cloisons de largeur comprise entre 500 nm et 50 µm ;
- l'élément mobile comprend en outre une structure de rigidification de la membrane ;
- le transducteur comprend en outre un premier bras de transmission, l'élément mobile étant couplé à une extrémité du premier bras de transmission ;
- le transducteur comprend en outre un dispositif de transmission d'un mouvement et d'une force entre une première zone et une deuxième zone à atmosphère contrôlée, les première et deuxième zones étant isolées l'une de l'autre de manière étanche, le dispositif de transmission comprenant, outre le premier bras de transmission qui s'étend dans la première zone, un deuxième bras de transmission s'étendant dans la deuxième zone.

Un deuxième aspect de l'invention concerne un procédé de fabrication d'un transducteur électroacoustique comprenant :
- un bâti ;;
- un élément mobile par rapport au bâti, l'élément mobile comprenant une membrane ;
- une cavité interne appelée volume arrière, soumise à une pression de référence et délimitée par l'élément mobile et des première et deuxième parois appartenant au bâti, la première paroi étant située dans le prolongement de la membrane et la deuxième paroi étant disposée en regard de la membrane ;

le procédé comprenant les étapes suivantes :
   - fournir un empilement comprenant successivement un substrat, une première couche sacrificielle et une première couche structurelle d'épaisseur inférieure à 2 µm ;
   - graver la première couche structurelle jusqu'à la première couche sacrificielle de façon à délimiter la membrane de l'élément mobile ;
   - reporter un capot sur la première couche structurelle, formant ainsi le volume arrière ;
   - graver le substrat pour accéder à la première couche sacrificielle ;
   - graver la première couche sacrificielle de façon à libérer la membrane ;
au moins une cavité étanche étant formée dans une portion de la première couche sacrificielle, de façon à être située dans la première paroi délimitant le volume arrière, ladite au moins une cavité étanche de la première paroi étant séparée du volume arrière par une première portion de la première couche structurelle et une pression inférieure à la pression de référence régnant dans ladite au moins une cavité étanche de la première paroi.

Le substrat peut être gravé de façon à délimiter un bras de transmission, l'élément mobile étant couplé à une extrémité du bras de transmission, la première couche sacrificielle servant de couche d'arrêt à la gravure du substrat.

De préférence, le procédé comprend en outre, après l'étape de fourniture de l'empilement et avant l'étape de report du capot, les étapes suivantes :
- former une deuxième couche sacrificielle sur la première couche structurelle ;
- former une deuxième couche structurelle sur la première couche structurelle et sur la deuxième couche sacrificielle ;
- graver la deuxième couche structurelle de façon à exposer la deuxième couche sacrificielle et à délimiter une structure de rigidification de la membrane ;
- graver la deuxième couche sacrificielle de façon à exposer la membrane.

Avantageusement, la première couche structurelle et la deuxième couche structurelle sont gravées simultanément de façon à délimiter la membrane et la structure de rigidification de l'élément mobile.

Dans un mode de mise en œuvre préférentiel du procédé, l'étape de fourniture de l'empilement comprend les sous-étapes suivantes :
- graver des première et deuxième cavités disjointes dans le substrat ;
- former la première couche sacrificielle sur le substrat, la première couche sacrificielle comprenant une première portion disposée dans la première cavité et une deuxième portion disposée dans la deuxième cavité ;
- graver au moins une troisième cavité dans la première portion de la première couche sacrificielle ;
- reporter la première couche structurelle sur les première et deuxième portions de la première couche sacrificielle, de manière à rendre étanche ladite au moins une troisième cavité.

Le procédé de fabrication peut également comprendre en outre une étape de fourniture du capot comprenant les sous-étapes suivantes :
- graver au moins une quatrième cavité dans un substrat additionnel ;
- reporter une troisième couche structurelle sur le substrat additionnel, de manière à rendre étanche ladite au moins une quatrième cavité.

L'invention et ses différentes applications seront mieux comprises à la lecture de la description qui suit et à l'examen des figures qui l'accompagnent.

### BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
[Fig. 1] représente en vue de coupe un transducteur électroacoustique selon un premier mode de réalisation de l'invention ;
[Fig. 2] représente en vue de coupe un transducteur électroacoustique selon unmode de réalisation non couvert par l'invention ;
[Fig. 3] représente en vue de coupe un transducteur électroacoustique selon un troisième mode de réalisation de l'invention ;
[Fig. 4A] à [Fig. 4L] représentent en vue de coupe des étapes d'un procédé de fabrication du transducteur électroacoustique selon la figure 1 ;
[Fig. 5A] à [Fig. 5D] représentent en vue de coupe des étapes d'un procédé de fabrication d'un capot employé dans le transducteur électroacoustique de la figure 2 ou 3.

Pour plus de clarté, les éléments identiques ou similaires sont repérés par des signes de référence identiques sur l'ensemble des figures.

### DESCRIPTION DETAILLEE

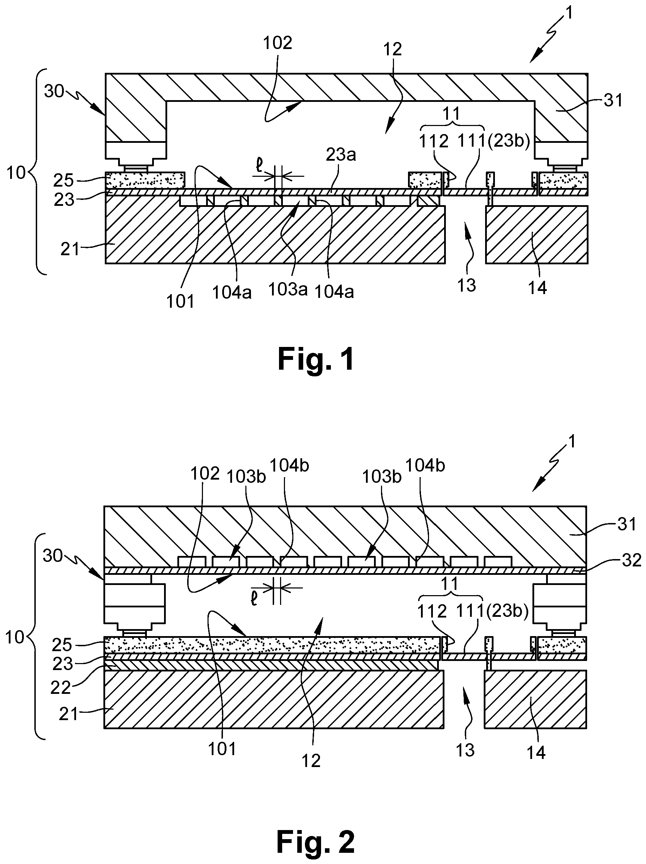

Les figures 1, 2 et 3 représentent différents modes de réalisation d'un transducteur électroacoustique 1 à faible bruit.

D'une manière commune à ces trois modes de réalisation, le transducteur électroacoustique 1 comprend un bâti 10, un élément mobile 11 par rapport au bâti 10 et une première cavité dite interne 12 où règne une pression de référence.

L'élément mobile 11, appelé ci-après piston, comprend une membrane 111 et, de préférence, une structure de rigidification 112 de la membrane 111.

La membrane 111 du piston 11, aussi appelée couche mince, est apte à se déplacer ou à se déformer sous l'effet d'une différence de pression entre ses deux faces. Elle sépare la première cavité 12 d'une deuxième cavité 13. Dans le cas d'un transducteur électroacoustique de type microphone ou haut-parleur, la deuxième cavité 13 est ouverte sur l'environnement extérieur, c'est-à-dire l'air. Une face de la membrane 111 est donc soumise à la pression de référence et une face opposée de la membrane 111 est soumise à la pression atmosphérique.

La première cavité 12 est communément appelé volume arrière (en référence à sa position derrière le piston). Ce volume arrière 12 peut être relié à la deuxième cavité 13 par un chemin acoustique, par exemple situé à la périphérie du piston 11 comme cela est représenté sur les figures 1 à 3. Ce chemin acoustique est dimensionné pour que la pression de référence soit égale à la pression atmosphérique filtrée de ses composantes dynamiques (à hautes fréquences). La différence de pression entre les deux faces de la membrane 111 est alors égale aux composantes dynamiques de la pression atmosphérique (qui constituent le son).

Alternativement, le volume arrière 12 peut être étanche. La pression de référence est alors décorrélée de la pression atmosphérique.

Lorsque la membrane 111 se déplace sous l'effet du différentiel de pression, le volume arrière 12 est comprimé ou étiré, sa pression change. Autrement dit, une partie de la variation de pression est transmise au volume arrière 12 via la membrane 111. Les variations de pression entraînent des variations de température au sein du volume arrière 12, qui entraînent à leur tour des dissipations thermiques aux frontières du volume arrière 12. Ce sont ces dissipations thermiques qui sont à l'origine du bruit acoustique dont souffre le transducteur électroacoustique.

Plus le volume arrière 12 est important, moins le transducteur électroacoustique 1 est sensible aux variations de température dans le volume arrière 12. Un bon compromis entre sensibilité aux variations de température et encombrement du transducteur électroacoustique 1 peut être obtenu pour un volume arrière 12 compris entre 1 mm³ et 100 mm³.

Le volume arrière 12 est délimité par l'élément mobile 11 et par des parois appartenant au bâti 10. Le volume arrière 12 est notamment délimité par une première paroi 101 située dans le prolongement de la membrane 111 et par une deuxième paroi 102 disposée en regard de la membrane 111. Autrement dit, la première paroi 101 et la membrane 111 sont situées d'un même côté du volume arrière 12 et la deuxième paroi 102 est située du côté opposé.

Afin de réduire le bruit acoustique généré par les dissipations thermiques lors de variations de température dans le volume arrière 12, au moins l'une des parois délimitant le volume arrière 12 comprend au moins une cavité étanche 103a, 103b. Chaque cavité étanche 103a, 103b est remplie d'un gaz ou d'un mélange gazeux, par exemple de l'air, qui exerce sur les parois de la cavité étanche 103a, 103b une pression (strictement) inférieure à la pression de référence. Autrement dit, une pression (strictement) inférieure à la pression de référence règne dans la cavité étanche 103a, 103b.

Chaque cavité étanche 103a ou 103b à l'intérieur d'une paroi du volume arrière 12 réduit la dissipation de chaleur à travers cette paroi. En d'autres termes, la cavité étanche 103a, 103b améliore l'isolation thermique de la paroi. Il en résulte une diminution de bruit acoustique en sortie de transducteur électroacoustique.

Plus la pression dans la cavité étanche 103a, 103b est faible, plus la dissipation de chaleur est réduite. La pression dans la cavité étanche 103a, 103b est avantageusement inférieure à 1000 Pa (10 mBar).

La pression qui règne dans la cavité étanche 103a, 103b peut être très faible, afin d'arriver à une configuration de quasi-vide. Elle est alors inférieure ou égale à 100 Pa (1 mbar).

De préférence, la cavité étanche 103a, 103b s'étend parallèlement à l'une au moins des surfaces du volume arrière 12.

Une paroi délimitant le volume arrière 12 peut comprendre une seule cavité étanche 103a, 103b à l'intérieur de laquelle sont disposés des piliers 104a, 104b (aussi appelés colonnes). Ces piliers 104a, 104b améliorent la résistance mécanique de la paroi. Ils présentent une largeur *l* qui est avantageusement comprise entre 500 nm et 50 µm. La largeur I, aussi appelée dimension critique, est la plus petite dimension des piliers 104a, 104b dans un plan parallèle aux faces de la membrane 111. Une telle largeur offre un bon compromis entre résistance mécanique de la paroi (à la pression de référence) et conduction thermique.

Alternativement, la paroi peut comprendre plusieurs cavités étanches 103a, 103b séparées les unes des autres par des cloisons dont la largeur l est avantageusement comprise entre 500 nm et 50 µm. Les différentes cavités étanches 103a ou 103b au sein d'une même paroi peuvent avoir une forme et des dimensions identiques.

Le nombre de piliers 104a, 104b (ou cloisons) par unité de surface dépend du compromis entre résistance mécanique de la paroi et conductivité thermique.

Afin de réduire la dissipation thermique de manière significative, la ou les cavités étanches 103a, 103b s'étendent dans au moins l'une des première et deuxième parois 101-102. Ces parois, dites principales, sont celles qui présentent les plus grandes superficies.

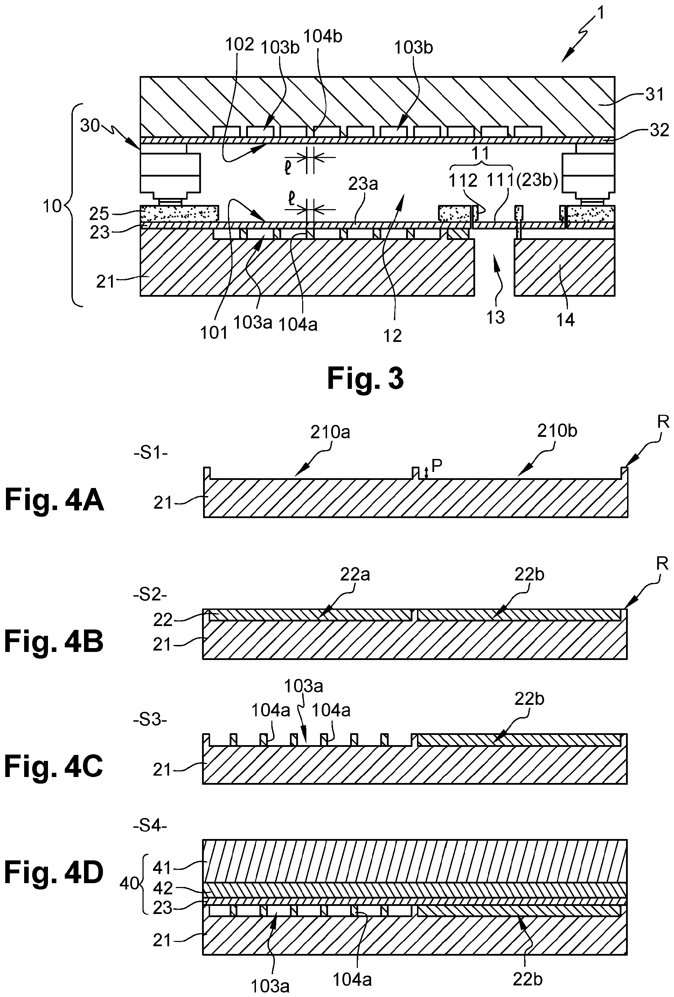

Ainsi, dans le mode de réalisation représenté par la figure 1, seule la première paroi 101 dans le prolongement de la membrane 111 comprend une ou plusieurs cavités étanches 103a. A l'inverse, dans le mode de réalisation de la figure 2, seule la deuxième paroi 102 comprend une ou plusieurs cavités étanches 103b. Enfin, dans le mode de réalisation de la figure 3, la première paroi 101 comprend une ou plusieurs (premières) cavités étanches 103a et la deuxième paroi 102 comprend une ou plusieurs (deuxièmes) cavités étanches 103b. Le nombre, la forme et/ou les dimensions des cavités étanches 103a, 103b peuvent différer entre les parois.

Dans ces trois modes de réalisation, le bâti 10 comprend un support 21, une première portion 23a d'une première couche structurelle 23 disposée sur le support 21 et un capot 30 disposé sur la première portion 23a de la première couche structurelle 23. De préférence, le support 21 est formé par un premier substrat (par exemple en silicium) et le capot 30 comprend un deuxième substrat 31 (par exemple en silicium).

Le bâti 10 peut comprendre en outre une deuxième couche structurelle 25 disposée entre la première portion 23a de la première couche structurelle 23 et le capot 30.

La cavité étanche 103a de la première paroi 101 est, dans les modes de réalisation des figures 1 et 3, séparée du volume arrière 12 par la première portion 23a de la première couche structurelle 23. Autrement dit, la première portion 23a de la première couche structurelle 23 constitue le « plafond » de la cavité étanche 103a. Les piliers 104a disposés à l'intérieur de la cavité étanche 103a (ou les cloisons qui séparent les cavités étanches 103a) s'étendent du support 21 jusqu'à la première portion 23a de la première couche structurelle 23. Les piliers 104a supportent ainsi la première portion 23a et l'empêche de s'effondrer, du fait de la différence de pression entre le volume arrière 12 et les cavités étanches 103a.

La première couche structurelle 23 présente une épaisseur inférieure ou égale à 2 µm. Ainsi, la première paroi 101 présente une inertie thermique faible. La membrane 111 du piston 11 est de préférence formée par une deuxième portion 23b de la première couche structurelle 23.

Dans les modes de réalisation des figures 2 et 3, la deuxième paroi 102 appartient au capot 30. La cavité étanche 103b de la deuxième paroi 102 est donc située dans le capot 30. Elle est avantageusement séparée du volume arrière 12 par une troisième couche structurelle 32 d'épaisseur inférieure à 2 µm. La troisième couche structurelle 32 (appartenant au capot 30) est disposée sur le deuxième substrat 31. Les piliers 104b disposés à l'intérieur de la cavité étanche 103b supportent la troisième couche structurelle 32.

Le transducteur électroacoustique 1 peut être un microphone à détection capacitive. Outre le piston 11, le transducteur électroacoustique 1 comprend alors des moyens de détection capacitive et un dispositif de transmission d'un mouvement entre l'élément mobile et les moyens de détection capacitive.

Le piston 11 est relié au dispositif de transmission de mouvement dans une première zone du microphone, ici la deuxième cavité 13.

Les moyens de détection capacitive permettent de mesurer le déplacement du piston 11, et donc la variation de pression atmosphérique. Ils sont disposés dans une deuxième zone du microphone, isolée de la première zone 13 de manière étanche et non représentée sur les figures. Ils comprennent une électrode mobile et au moins une électrode fixe disposée en regard de l'électrode mobile. Les électrodes forment les armatures d'un condensateur dont la capacité varie en fonction du déplacement du piston 11. La deuxième zone est de préférence une chambre sous atmosphère contrôlée pour réduire les phénomènes de frottement visqueux et les bruits acoustiques associés. Par « chambre sous atmosphère contrôlée », on entend une chambre sous une pression réduite, typiquement inférieure à 1000 Pa (10 mbar), et de préférence sous vide (< 100 Pa ou 1 mbar).

Le dispositif de transmission comprend au moins un premier bras de transmission 14 s'étendant dans la première zone 13 et au moins un deuxième bras de transmission s'étendant dans la deuxième zone. Le piston 11 est couplé à une première extrémité du premier bras de transmission 14, tandis que l'électrode mobile des moyens de détection capacitive est couplée à une extrémité du deuxième bras de transmission. Les premier et deuxième bras de transmission sont reliés à leur deuxième extrémité par l'intermédiaire d'une articulation pivot. Cette articulation pivot autorise une rotation des bras de transmission par rapport au bâti 10 du microphone et assure simultanément l'étanchéité entre les première et deuxième zones.

Les figures 4A à 4L représentent des étapes S1 à S12 d'un procédé de fabrication du transducteur électroacoustique 1 selon la figure 1, selon un mode de mise en œuvre préférentiel de l'invention.

Les étapes S1 à S5, illustrées par les figures 4A-4E, sont relatives à la formation d'un empilement 20 comprenant successivement le substrat 21, une première couche sacrificielle 22 et la première couche structurelle 23, ainsi qu'à la formation des cavités étanches 103a dans une portion de la première couche sacrificielle 22.

Ainsi, en référence à la figure 4A, le procédé de fabrication débute par une étape S1 de gravure d'une première cavité 210a et d'une deuxième cavité 210b dans le substrat 21. Les première et deuxième cavités 210a-210b sont disjointes, c'est-à-dire qu'elles sont séparées par une portion du substrat 21. Elles ont de préférence la même profondeur P, par exemple comprise entre 100 nm et 10 µm. La profondeur P première et deuxième cavités 210a-210b est mesurée depuis la surface initiale du substrat 21, appelée ci-après surface de référence R.

Le substrat 21 sert notamment à réaliser le premier bras de transmission 14 et une partie du bâti (le support). Il présente initialement une épaisseur qui peut être comprise entre 500 µm et 700 µm. Le substrat 21 est de préférence un substrat semi-conducteur dit massif (ou « bulk » en anglais), par exemple en silicium.

Puis, à l'étape S2 de la figure 4B, la première couche sacrificielle 22 est formée sur le substrat 21. La première couche sacrificielle 22 comprend une première portion 22a disposée dans la première cavité 210a et une deuxième portion 22b disposée dans la deuxième cavité 210b. Les première et deuxième portions 22a-22b de la première couche sacrificielle 22 ont de préférence la même épaisseur.

La première couche sacrificielle 22 est avantageusement déposée de manière à remplir entièrement les première et deuxième cavités 210a-210b du substrat 21. Par exemple, la première couche sacrificielle 22 est formée par dépôt chimique en phase vapeur assisté par plasma (ou PECVD) puis recuit. Cette opération de dépôt est suivie d'une opération de planarisation, par exemple par polissage mécano-chimique (ou CMP, pour « chemical mechanical polishing » en anglais), afin d'obtenir une surface plane avec la surface de référence R du substrat 21.

La première couche sacrificielle 22 a vocation à disparaître en partie lors de la réalisation du transducteur. Cette couche est notamment utile pour la délimitation du premier bras de transmission 14. Elle peut également servir d'entrefer inférieur dans la zone de détection capacitive du transducteur (non représentée sur les figures). Elle peut également permettre de lier mécaniquement le substrat 21 et la première couche structurelle 23. La première couche sacrificielle 22 peut être constituée d'un matériau diélectrique, de préférence un nitrure de silicium ou un oxyde de silicium, par exemple le dioxyde de silicium (SiO₂). Son épaisseur est par exemple comprise entre 100 nm et 10 µm.

L'étape S3 de la figure 4C consiste à graver au moins une cavité 103a dans la première portion 22a de la première couche sacrificielle 22. La cavité 103a s'étend de préférence jusqu'au substrat 21. Elle contient des piliers 104a formés au moins en partie du matériau de de la première couche sacrificielle 22. Autrement dit, la première portion 22a de la première couche sacrificielle 22 est structurée sous la forme de piliers 104a. Alternativement, la première portion 22a de la première couche sacrificielle 22 est gravée sous la forme de cloisons séparant différentes cavités 103a.

La première portion 22a de la première couche sacrificielle 22 est de préférence gravée de manière sélective par rapport au substrat 21. Les piliers 104a ou cloisons sont alors constitués uniquement du matériau de la première couche sacrificielle 22.

Les piliers 104a ou cloisons peuvent adopter différentes formes. Les piliers 104a sont par exemple des cylindres de section ronde, carrée ou octogonale. Les cloisons sont par exemple des lignes parallèles entre elles. Les cloisons peuvent également former un quadrillage (lignes s'étendant dans deux directions sécantes, de préférence perpendiculaires), chaque maille du quadrillage correspondant alors à une cavité 103a.

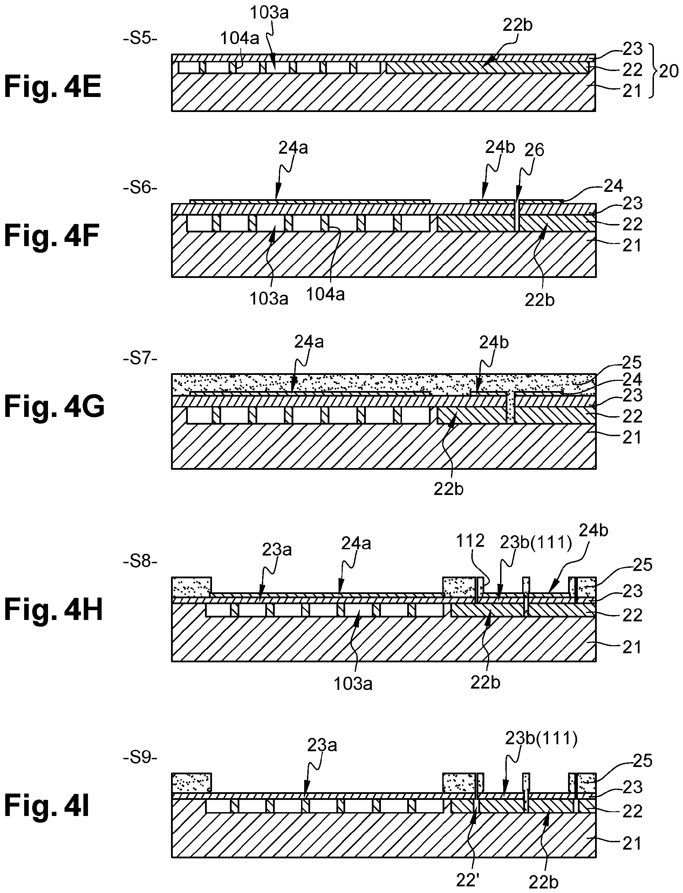

Le procédé de fabrication comprend ensuite une étape de report de la première couche structurelle 23 sur la première portion 22a de la première couche sacrificielle 22 (piliers 104a ou cloisons) et sur la deuxième portion 22b de la première couche sacrificielle 22, de sorte à fermer la (ou les) cavité(s) 103a de manière étanche (Fig.4E). La première couche structurelle 23 peut être constituée du même matériau que le substrat 21, par exemple le silicium.

Les figures 4D et 4E représentent un mode de mise en œuvre préférentiel de cette étape de report. La première couche structurelle 23 appartient initialement à un substrat de report 40. Elle est reportée sur les première et deuxième portions 22a-22b de la première couche sacrificielle 22 grâce à une technique de collage direct.

Ainsi, à l'étape S4 de la figure 4D, le substrat de report 40 est collé au substrat 21 recouvert de la première couche sacrificielle 22 en mettant en contact la première couche structurelle 23 avec les piliers 104a et la deuxième portion 22b de la première couche sacrificielle 22.

Puis, à l'étape S5 de la figure 4E, le substrat de report 40 est aminci jusqu'à la première couche structurelle 23. L'amincissement du substrat de report 40 peut être accompli par gravure ou par broyage (« grinding » en anglais) et CMP.

Le substrat de report 40 est de préférence une structure multicouche de type SOI comprenant successivement une couche de support 41 (typiquement en silicium), une couche d'oxyde enterrée 42 (typiquement en SiO₂) et un film mince de silicium formant la première couche structurelle 23. Le substrat de report 40 est aminci en retirant successivement la couche de support 41 et la couche d'oxyde enterrée 42.

La première couche structurelle 23 sert notamment à réaliser la membrane 111 du piston 11. Elle peut également servir à réaliser l'électrode mobile des moyens de détection capacitive. Elle présente une épaisseur inférieure à celle du substrat 21, de préférence comprise entre 100 nm et 10 µm, et plus préférentiellement encore inférieure ou égale à 2 µm.

Le procédé de fabrication se poursuit avec les étapes S6 à S12 décrites ci-dessous en relation avec les figures 4F à 4L.

A l'étape S6 de la figure 4F, une deuxième couche sacrificielle 24 est formée sur la première couche structurelle 23. La deuxième couche sacrificielle 24 comprend une première portion 24a disposée en regard des cavités étanches 103a et une deuxième portion 24b disposée en regard de la deuxième portion 22b de la première couche sacrificielle 22. Les première et deuxième portions 24a-24b de la deuxième couche sacrificielle 24 sont disjointes.

La deuxième couche sacrificielle 24 peut être d'abord déposée de façon à recouvrir entièrement la première couche structurelle 23 puis gravée partiellement, par exemple au travers d'un masque en résine formé par photolithographie, pour former les première et deuxième portions 24a-24b. La gravure de la deuxième couche sacrificielle 24 est de préférence sélective par rapport à la première couche structurelle 23. La deuxième couche sacrificielle 24 est avantageusement formée du même matériau diélectrique que la première couche sacrificielle 22, par exemple un oxyde de silicium. Son épaisseur peut être comprise entre 100 nm et 10 µm.

La deuxième couche sacrificielle 24 peut servir d'entrefer supérieur pour la détection capacitive.

A l'étape S7 de la figure 4G, une deuxième couche structurelle 25 est formée sur la première couche structurelle 23 et sur la deuxième couche sacrificielle 24, par exemple par épitaxie. La deuxième couche structurelle 25 est destinée à former un ou plusieurs éléments (structurels) du transducteur, en particulier la structure de rigidification 112 du piston 11. Elle est avantageusement constituée du même matériau que la première couche structurelle 23, par exemple de silicium. L'épaisseur de la deuxième couche structurelle 25 est de préférence comprise entre 5 µm et 50 µm, par exemple égale à 20 µm.

Avant l'étape S7 de formation de la deuxième couche structurelle 25, le procédé de fabrication peut comprendre une étape dite d'ouverture de la première couche structurelle 23 et de la deuxième portion 22b de la première couche sacrificielle 22. Cette étape d'ouverture consiste à former un puits 26 qui s'étend à travers la première couche structurelle 23 et la deuxième portion 22b de la première couche sacrificielle 22 jusqu'au substrat 21. Ce puits 26 est formé en gravant successivement la première couche structurelle 23 et la deuxième portion 22b de la première couche sacrificielle 22, de préférence à travers la deuxième portion 24b de la deuxième couche sacrificielle 24. Le puits 26 permet au matériau de la deuxième couche structurelle 25 (par exemple du silicium) de croître du substrat 21 jusqu'à la première couche structurelle 23, formant ainsi un pilier qui traverse la deuxième portion 22b de la première couche sacrificielle 22. Ce pilier assurera la connexion entre la membrane 111 du piston 11 (formée dans la première couche structurelle 23) et le premier bras de transmission 14 (formé dans le substrat 21).

Puis, lors d'une étape S8 représentée par la figure 4H, la deuxième couche structurelle 25 est gravée de façon à délimiter les contours de la structure de rigidification 112 (détourage du piston), à alléger le piston 11 et à réduire le volume de matériau au-dessus de la cavité étanche 103a. Les première et deuxième portions 24a-24b de la deuxième couche sacrificielle 24 (ex. en oxyde de silicium) servent de couche d'arrêt à la gravure de la deuxième couche structurelle 25 (ex. en silicium), préservant ainsi la première couche structurelle 23 sous-jacente (ex. en silicium). La gravure de la deuxième couche structurelle 25 est donc sélective par rapport à la deuxième couche sacrificielle 24.

En revanche, entre les première et deuxième portions 24a-24b de la deuxième couche sacrificielle 24, la gravure de la deuxième couche structurelle 25 pour délimiter la périphérie (ou le contour extérieur) de la structure de rigidification 112 débouche sur la première couche structurelle 23. La gravure de la deuxième couche structurelle 25 n'étant pas sélective par rapport à la première couche structurelle 23 (mais uniquement par rapport aux première et deuxième couches sacrificielles 22, 24), la première couche structurelle 23 est gravée en même temps que la deuxième couche structurelle 25 jusqu'à la deuxième portion 22b de la première couche sacrificielle 22.

Ainsi, au fond de la tranchée correspondant à la périphérie de la structure de rigidification 112, la première couche structurelle 23 a été gravée et la deuxième portion 22b de la première couche sacrificielle 22 est exposée.

A l'issue de l'étape S8, la première couche structurelle 23 comprend une première portion 23a et une deuxième portion 23b séparées l'une de l'autre. La première portion 23a de la première couche structurelle 23 (à gauche sur la figure 4H) recouvre la cavité étanche 103a. Elle est recouverte par la première portion 24a de la deuxième couche sacrificielle 24 et par une portion résiduelle de la deuxième couche structurelle 25. La deuxième portion 23b de la première couche structurelle 23 (à droite) est destinée à former la membrane 111 du piston 11. Elle est recouverte par la deuxième portion 24b de la deuxième couche sacrificielle 24 et par une portion solidaire de la deuxième couche structurelle 25 formant la structure de rigidification 112.

La technique de gravure employée à l'étape S8 de la figure 4H est avantageusement la gravure ionique réactive profonde (ou DRIE, pour « Deep Reactive Ion Etching » en anglais).

La gravure de la première couche structurelle 23 débouche avantageusement sur la deuxième portion 22b de la première couche sacrificielle 22.

Une alternative consiste à graver la deuxième couche structurelle 25 et la première couche structurelle 23 séparément, en utilisant des chimies de gravure différentes, lorsque les deux couches sont formées de matériaux différents.

En référence à la figure 4I, le procédé de fabrication comprend ensuite une étape S9 de gravure de la deuxième couche sacrificielle 24 de façon à exposer (partiellement) la deuxième portion 23b de la première couche structurelle 23 (autrement dit de façon à exposer une première face de la membrane 111). Cette étape S9 peut être qualifiée de première étape de libération du piston 11. La première portion 23a de la première couche structurelle 23 est également exposée à l'issue de cette étape.

La gravure de la deuxième couche sacrificielle 24 est de préférence une gravure isotrope sélective par rapport au substrat 21, à la première couche structurelle 23 et à la deuxième couche structurelle 25. La deuxième couche sacrificielle 24 est de préférence gravée chimiquement, par exemple en plongeant l'empilement dans un bain d'acide fluorhydrique (HF) en phase liquide ou vapeur (dans le cas d'une couche en oxyde de silicium) pendant un temps maîtrisé.

En revanche, une partie de la première couche sacrificielle 22 (plus particulièrement de la deuxième portion 22b) située à l'aplomb de la périphérie de la structure de rigidification 112 est gravée en même temps que la deuxième couche sacrificielle 24, ce qui forme une cavité 22' dans la première couche sacrificielle 22. La gravure peut être contrôlée en temps de sorte que cette cavité 22' soit peu étendue.

La gravure des couches sacrificielles 22 et 24 peut également servir à libérer l'électrode mobile des moyens de détection capacitive (avant qu'elle ne soit enfermée dans la chambre sous atmosphère contrôlée).

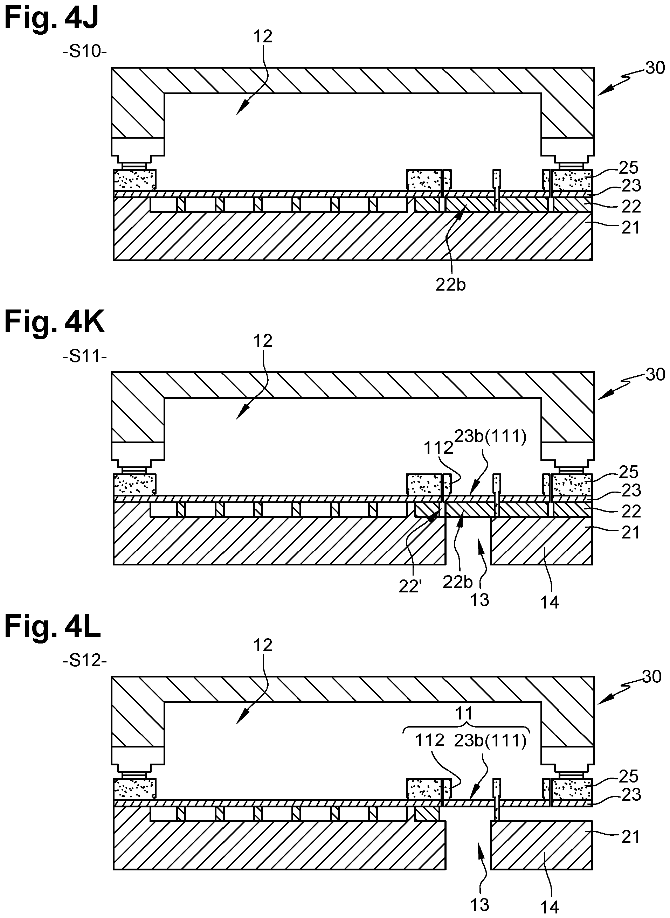

En référence à la figure 4J, le procédé de fabrication comprend ensuite une étape S10 de report du capot 30 sur la partie de la deuxième couche structurelle 25 appartenant au bâti 10, formant ainsi le volume arrière 12 (et la chambre sous atmosphère contrôlée). Le capot 30 peut notamment être fixé à la deuxième couche structurelle 25 par collage direct (par exemple Si-Si) ou par scellement eutectique (par exemple Au-Si ou Al-Ge).

L'assemblage formé par l'empilement de couches 21-25 et le capot 30 peut ensuite être retourné, pour faciliter la gravure ultérieure du substrat 21. Après ce retournement, le substrat 21 est avantageusement aminci, par exemple par gravure DRIE ou par broyage (« grinding » en anglais) puis CMP, de préférence jusqu'à atteindre une épaisseur comprise entre 30 µm à 300 µm, soit l'épaisseur souhaitée pour le premier bras de transmission 14.

L'étape S11 de la figure 4K consiste à graver le substrat 21 (éventuellement aminci) jusqu'à la première couche sacrificielle 22 de façon à créer un accès jusqu'au piston 11 et à délimiter le premier bras de transmission 14. La gravure du substrat 21 est de préférence sélective par rapport à la première couche sacrificielle 22. Le substrat 21 peut être gravé par DRIE.

Comme cela est illustré sur la figure 4K, la gravure du substrat 21 pour créer un accès vers la face arrière du piston 11 peut être inscrite à l'intérieur de la périphérie du piston 11, de façon à ne pas déboucher sur la cavité 22' formée à l'étape S9 (cf. Fig. 4I) par la gravure partielle (et involontaire) de la première couche sacrificielle 22. Ainsi, la gravure de l'étape S11 ne s'étend pas au piston 11 comprenant la deuxième portion 23b de la première couche structurelle 23 (membrane 111) et la portion désolidarisée de la deuxième couche structurelle 25 (structure de rigidification 112). A l'intérieur de la périphérie du piston 11, la première couche sacrificielle 22 (ex. en oxyde de silicium) sert de couche d'arrêt à la gravure du substrat 21 (ex. en silicium), préservant ainsi la deuxième portion 23b de la première couche structurelle 23 sous-jacente (ex. en silicium). Cela évite de créer des fuites d'air importantes entre le volume arrière 12 (soumis à la pression de référence) et la deuxième cavité 13 ouverte sur l'environnement extérieur (et donc soumise à la pression atmosphérique), de part et d'autre de la membrane 111.

Enfin, à l'étape S12 (cf. Fig. 4L), la première couche sacrificielle 22 est gravée de façon à découvrir la deuxième portion 23b de la première couche structurelle 23 (autrement dit de façon à exposer une deuxième face opposée de la membrane 111) et la désolidariser du substrat 21 (ici seule la deuxième portion 22b de première couche sacrificielle 22 est gravée). A l'issue de l'étape S12, le piston 11 est libre de se déplacer. L'étape S12 peut donc être qualifiée de deuxième étape de libération du piston 11.

La gravure de la première couche sacrificielle 22 est de préférence une gravure isotrope sélective par rapport au substrat 21, à la première couche structurelle 23 et à la deuxième couche structurelle 25. La première couche sacrificielle 22 est de préférence gravée chimiquement, par exemple en plongeant l'assemblage dans un bain d'acide fluorhydrique (HF) en phase liquide ou vapeur (dans le cas d'une couche en oxyde de silicium) pendant un temps maîtrisé.

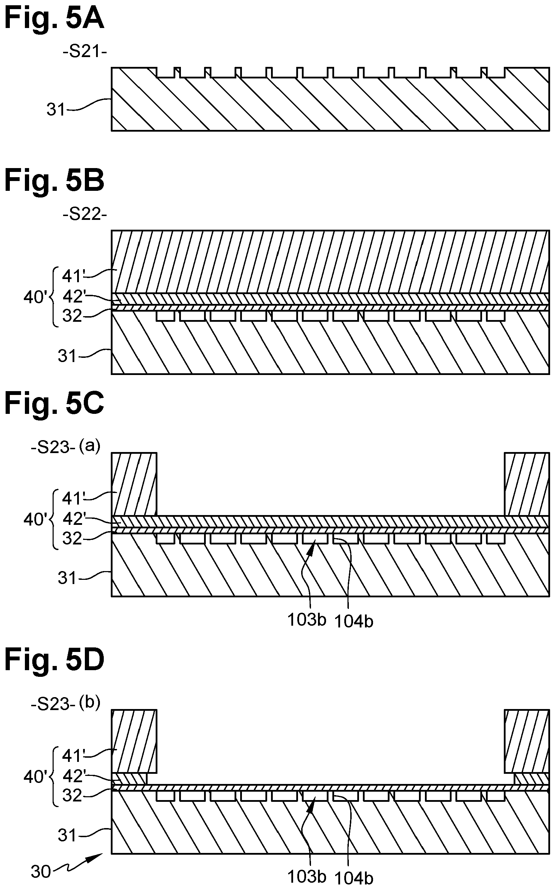

Les figures 5A-5D représentent des étapes d'un procédé de fabrication du capot 30 employé dans le transducteur électroacoustique 1 des figures 2 et 3.

Lors d'une première étape S21 représentée par la figure 5A, un deuxième substrat 31 (de préférence en matériau semi-conducteur, par exemple en silicium) est gravé de manière à former une cavité 103b comprenant avantageusement des piliers 104b ou plusieurs cavités 103b séparées (latéralement) par des cloisons. Chaque pilier 104b ou cloison est formé par une portion en saillie du substrat 31.

Puis, lors d'une deuxième étape illustrée par les figures 5B-5D, une troisième couche structurelle 32 est reportée sur le substrat 21, de manière à rendre étanches la ou les cavités 103b.

A l'instar de l'étape de report de la première couche structurelle 23 décrite en relation les figures 4D-4E, l'étape de report de la troisième couche structurelle 32 peut comprendre deux sous-étapes S22-S23 :
- le collage S22 sur le deuxième substrat 31 d'un substrat de report 40' (de préférence une structure multicouche SOI) comprenant la troisième couche structurelle 32 (cf. Fig.5B) ;
- l'amincissement S23 du substrat de report 40' jusqu'à la troisième couche structurelle 32, par exemple par gravure ou par broyage et CMP (cf. Figs.5C-5D).

Le substrat de report 40' est aminci jusqu'à la troisième couche structurelle 32 au moins en regard de la cavité 104b. Une ou plusieurs portions du substrat de report 40' peuvent être conservées autour de la cavité étanche 104b, afin d'augmenter le volume arrière 12. Dans le cas d'une structure multicouche SOI, l'amincissement S23 du substrat de report 40' peut être effectué en deux opérations successives illustrées par les figures 5C et 5D :
- S23 (a) : gravure de la couche de support 41' (typiquement en silicium) de la structure multicouche jusqu'à la couche d'oxyde enterrée 42' (typiquement en SiO₂) (cf.Fig.5C) ; et
- S23 (b) : gravure de la couche d'oxyde enterrée 42' sélectivement par rapport à la troisième couche structurelle 32, de préférence par gravure humide (ex. HF) (cf.Fig.5D).

De manière plus générale, le procédé de fabrication des figures 5A-5D permet d'obtenir une structure 30 munie d'une ou plusieurs cavités étanches 103b en surface. Cette structure peut trouver d'autres applications que le capot du transducteur acoustique 1.

Pour obtenir le transducteur électroacoustique 1 selon la figure 3, le procédé de fabrication de transducteur selon les figures 4A-4L est mis en œuvre en reportant, à l'étape S10 de la figure 4J, un capot 30 obtenu par la mise en œuvre du procédé des figures 5A-5D.

Pour obtenir le transducteur électroacoustique 1 selon la figure 2, les étapes des figures 5A-5D sont mises en œuvre pour fabriquer le capot 30 et une variante du procédé de fabrication de transducteur selon les figures 4A-4L est mise en œuvre.

L'empilement 20 utilisé comme point de départ de cette variante de procédé comprend successivement le substrat 21, la première couche sacrificielle 22 et la première couche structurelle 23, mais pas de cavités étanches 103a aménagées à l'intérieur de la première couche sacrificielle 22 (cf. Fig.2). La première couche sacrificielle 22 s'étend alors sur toute la surface du substrat 21. Typiquement, l'empilement 20 peut être une structure multicouche de type SOI.

La variante de procédé ne comprend alors aucune des étapes S1-S5 visant à former la cavité étanche 103a (de la première paroi 101), mais simplement une étape de fourniture de l'empilement 20. La deuxième couche sacrificielle 24 peut ne pas comprendre la première portion 24a et la deuxième couche structurelle 25 peut ne pas être gravée en dehors du piston (bien que cela soit utile pour agrandir le volume arrière 12).

Le piston 11 peut être dépourvu de structure de rigidification 112. Les étapes S6 (formation de la deuxième couche sacrificielle 24), S7 (formation de la deuxième couche structurelle 25), S8 (gravure de la deuxième couche structurelle 25) et S9 (retrait de la deuxième couche sacrificielle 24) peuvent alors ne pas être mises en œuvre.

Ainsi, de manière plus générale, le procédé de fabrication de transducteur électroacoustique selon l'invention comprend les étapes suivantes :
- fournir un empilement 20 comprenant successivement le substrat 21, la première couche sacrificielle 22 et la première couche structurelle 23 ;
- graver la première couche structurelle 23 jusqu'à la première couche sacrificielle 22 de façon à délimiter la membrane 111 de l'élément mobile 11;
- reporter un capot 30 sur la première couche structurelle 23, formant ainsi le volume arrière 12 ;
- graver le substrat 21 pour accéder à la première couche sacrificielle 22 ;
- graver la première couche sacrificielle 22 de façon à libérer la membrane 111;
au moins une cavité étanche 103a, 103b étant formée dans une portion de la première couche sacrificielle 22 et/ou dans le capot 30.

Le procédé de fabrication a en outre été décrit en prenant pour exemple un microphone à détection capacitive, dont une face est soumise à la pression atmosphérique et l'autre face soumise à une pression de référence. Le procédé de fabrication est cependant applicable à d'autres types de microphone et à d'autres types de transducteur électroacoustique, notamment un haut-parleur (émetteur sonore) ou un émetteur ultrasonore.

De façon plus générale, un microphone comprend dans la deuxième zone (chambre à atmosphère contrôlée) des moyens de mesure d'un mouvement du dispositif de transmission et/ou d'une force appliquée au dispositif de transmission. Ces moyens de mesure comprennent par exemple une poutre vibrante (microphone à détection résonante).

Dans le cas d'un haut-parleur ou d'un émetteur ultrasonore, un actionneur (par exemple capacitif) remplace les moyens de mesure dans la deuxième zone. L'actionneur met en mouvement la première extrémité du deuxième bras de transmission. Ce mouvement est transmis par le dispositif de transmission au piston 11 solidaire de la première extrémité du premier bras de transmission 14. Le mouvement de la membrane 111 du piston 11 permet d'émettre un son (ou des ultrasons).

## Revendications

1. Transducteur électroacoustique (1) comprenant :
- un bâti (10) comprenant un support (21), une première portion (23a) d'une première couche structurelle (23) disposée sur le support (21) et un capot (30) disposé sur la première portion (23a) de la première couche structurelle (23), la première couche structurelle (23) présentant une épaisseur inférieure à 2 µm ;
- un élément mobile (11) par rapport au bâti (10), l'élément mobile (11) comprenant une membrane (111) ;
- une cavité interne appelée volume arrière (12), soumise à une pression de référence et délimitée par l'élément mobile (11) et des première et deuxième parois (101, 102) appartenant au bâti (10), la première paroi (101) étant située dans le prolongement de la membrane (111) et la deuxième paroi (102) étant disposée en regard de la membrane (111) ;
**caractérisé en ce que** la première paroi (101) comprend au moins une cavité étanche (103a) séparée du volume arrière (12) par la première portion (23a) de la première couche structurelle (23) et dans lequel une pression inférieure à la pression de référence règne dans ladite au moins une cavité étanche (103a) de la première paroi (101).

2. Transducteur électroacoustique (1) selon la revendication 1, dans lequel la pression dans ladite au moins une cavité étanche (103a, 103b) est inférieure ou égale à 1000 Pa, de préférence inférieure ou égale à 100 Pa.

3. Transducteur électroacoustique (1) selon l'une des revendications 1 et 2, dans lequel la membrane (111) est formée par une deuxième portion (23b) de la première couche structurelle (23).

4. Transducteur électroacoustique (1) selon l'une quelconque des revendications 1 à 3, dans lequel la deuxième paroi (102) comprend au moins une cavité étanche (103b), dans lequel une pression inférieure à la pression de référence règne dans ladite au moins une cavité étanche (103b) de la deuxième paroi (102) et dans lequel ladite au moins une cavité étanche (103b) de la deuxième paroi (102) est située dans le capot (30) et séparée du volume arrière (12) par une troisième couche structurelle (32) d'épaisseur inférieure à 2 µm.

5. Transducteur électroacoustique (1) selon l'une quelconque des revendications 1 à 4, dans lequel au moins une des première et deuxièmes parois (101, 102) délimitant le volume arrière (12) comprend une unique cavité étanche (103a, 103b), l'unique cavité étanche (103a, 103b) comprenant des piliers (104a, 104b) de largeur comprise entre 500 nm et 50 µm.

6. Transducteur électroacoustique (1) selon l'une quelconque des revendications 1 à 4, dans lequel au moins une des première et deuxièmes parois (101, 102) délimitant le volume arrière comprend plusieurs cavités étanches (103a, 103b) séparées entre elles par des cloisons de largeur comprise entre 500 nm et 50 µm.

7. Procédé de fabrication d'un transducteur électroacoustique (1) comprenant :
- un bâti (10) ;
- un élément mobile (11) par rapport au bâti (10), l'élément mobile (11) comprenant une membrane (111) ;
- une cavité interne appelée volume arrière (12), soumise à une pression de référence et délimitée par l'élément mobile (11) et des première et deuxième parois (101, 102) appartenant au bâti (10), la première paroi (101) étant située dans le prolongement de la membrane (111) et la deuxième paroi (102) étant disposée en regard de la membrane (111) ;
procédé comprenant les étapes suivantes :
- fournir un empilement (20) comprenant successivement un substrat (21), une première couche sacrificielle (22) et une première couche structurelle (23) d'épaisseur inférieure à 2 µm ;
- graver la première couche structurelle (23) jusqu'à la première couche sacrificielle (22) de façon à délimiter la membrane (111) de l'élément mobile (11) ;
- reporter (S10) un capot (30) sur la première couche structurelle (23), formant ainsi le volume arrière (12) ;
- graver (S11) le substrat (21) pour accéder à la première couche sacrificielle (22) ;
- graver (S12) la première couche sacrificielle (22) de façon à libérer la membrane (111) ;
**caractérisé en ce qu'**au moins une cavité étanche (103a) est formée dans une portion (22a) de la première couche sacrificielle (22), de façon à être située dans la première paroi (101) délimitant le volume arrière (12), ladite au moins une cavité étanche (103a) de la première paroi (101) étant séparée du volume arrière (12) par une première portion (23a) de la première couche structurelle (23) et une pression inférieure à la pression de référence régnant dans ladite au moins une cavité étanche (103a) de la première paroi (101).

8. Procédé selon la revendication 7, dans lequel le substrat (21) est gravé de façon à délimiter un bras de transmission (14), l'élément mobile (11) étant couplé à une extrémité du bras de transmission (14), la première couche sacrificielle (22) servant de couche d'arrêt à la gravure du substrat (21).

9. Procédé selon l'une des revendications 7 et 8, comprenant en outre, après l'étape de fourniture de l'empilement (20) et avant l'étape (S10) de report du capot (30), les étapes suivantes :
- former (S6) une deuxième couche sacrificielle (24) sur la première couche structurelle (23) ;
- former (S7) une deuxième couche structurelle (25) sur la première couche structurelle (23) et sur la deuxième couche sacrificielle (24) ;
- graver (S8) la deuxième couche structurelle (25) de façon à exposer la deuxième couche sacrificielle (24) et à délimiter une structure de rigidification (112) de la membrane (111) ;
- graver (S9) la deuxième couche sacrificielle (24) de façon à exposer la membrane (111).

10. Procédé selon la revendication 9, dans lequel la première couche structurelle (23) et la deuxième couche structurelle (25) sont gravées simultanément de façon à délimiter la membrane (111) et la structure de rigidification (112) de l'élément mobile (11).

11. Procédé selon l'une quelconque des revendications 7 à 10, dans lequel l'étape de fourniture de l'empilement (20) comprend les sous-étapes suivantes :
- graver (S1) des première et deuxième cavités (210a, 210b) disjointes dans le substrat (21) ;
- former (S2) la première couche sacrificielle (22) sur le substrat (21), la première couche sacrificielle (22) comprenant une première portion (22a) disposée dans la première cavité (210a) et une deuxième portion (22b) disposée dans la deuxième cavité (210b) ;
- graver (S3) au moins une troisième cavité (103a) dans la première portion (22a) de la première couche sacrificielle (22) ;
- reporter (S4, S5) la première couche structurelle (23) sur les première et deuxième portions (22a-22b) de la première couche sacrificielle (22), de manière à rendre étanche ladite au moins une troisième cavité (103a).

12. Procédé selon l'une quelconque des revendications 7 à 11, comprenant en outre une étape de fourniture du capot (30) comprenant les sous-étapes suivantes :
- graver (S21) au moins une quatrième cavité (103b) dans un substrat additionnel (31) ;
- reporter (S22, S23) une troisième couche structurelle (32) sur le substrat additionnel (31), de manière à rendre étanche ladite au moins une quatrième cavité (103b).

## Patentansprüche

1. Elektroakustischer Wandler (1), umfassend:
- ein Gestell (10) mit einem Träger (21), einem ersten Abschnitt (23a) einer ersten Strukturschicht (23), der auf dem Träger (21) angeordnet ist, und eine Abdeckung (30), die auf dem ersten Abschnitt (23a) der ersten Strukturschicht (23) angeordnet ist, wobei die erste Strukturschicht (23) eine Dicke von weniger als 2 pm aufweist;
- ein bewegliches Element (11) in Bezug zum Gestell (10), wobei das bewegliche Element (11) eine Membran (111) umfasst;
- einen als hinteres Volumen (12) bezeichneten inneren Hohlraum, der einem Referenzdruck ausgesetzt ist und durch das bewegliche Element (11) und eine erste und eine zweite Wand (101, 102), die zum Gestell (10) gehören, begrenzt wird, wobei die erste Wand (101) in der Verlängerung der Membran (111) liegt und die zweite Wand (102) gegenüber der Membran (111) angeordnet ist;
**dadurch gekennzeichnet, dass** die erste Wand (101) mindestens einen abgedichteten Hohlraum (103a) umfasst, der von dem hinteren Volumen (12) durch den ersten Abschnitt (23a) der ersten Strukturschicht (23) getrennt ist, und wobei in dem mindestens einen abgedichteten Hohlraum (103a) der ersten Wand (101) ein Druck herrscht, der niedriger als der Referenzdruck ist.

2. Elektroakustischer Wandler (1) nach Anspruch 1, in dem der Druck in dem mindestens einen abgedichteten Hohlraum (103a, 103b) weniger als oder gleich 1000 Pa, vorzugsweise weniger als oder gleich 100 Pa, beträgt.

3. Elektroakustischer Wandler (1) nach einem der Ansprüche 1 oder 2, in dem die Membran (111) durch einen zweiten Abschnitt (23b) der ersten Strukturschicht (23) gebildet wird.

4. Elektroakustischer Wandler (1) nach einem der Ansprüche 1 bis 3, in dem die zweite Wand (102) mindestens einen abgedichteten Hohlraum (103b) aufweist, wobei in dem mindestens einen abgedichteten Hohlraum (103b) der zweiten Wand (102) ein Druck herrscht, der geringer ist als der Referenzdruck, und wobei der mindestens eine abgedichtete Hohlraum (103b) der zweiten Wand (102) in der Abdeckung (30) angeordnet und vom hinteren Volumen (12) durch eine dritte Strukturschicht (32) mit einer Dicke von weniger als 2 pm getrennt ist.

5. Elektroakustischer Wandler (1) nach einem der Ansprüche 1 bis 4, in dem mindestens eine der ersten und zweiten Wände (101, 102), die das hintere Volumen (12) begrenzen, einen einzelnen abgedichteten Hohlraum (103a, 103b) umfasst, wobei der einzelne abgedichtete Hohlraum (103a, 103b) Säulen (104a, 104b) mit einer Breite zwischen 500 nm und 50 µm umfasst.

6. Elektroakustischer Wandler (1) nach einem der Ansprüche 1 bis 4, in dem mindestens eine der ersten und zweiten Wände (101, 102), die das hintere Volumen begrenzen, mehrere dichte Hohlräume (103a, 103b) umfasst, die durch Trennwände mit einer Breite zwischen 500 nm und 50 µm voneinander getrennt sind.

7. Verfahren zur Herstellung eines elektroakustischen Wandlers (1), umfassend:
- ein Gestell (10);
- ein in Bezug zum Gestell (10) bewegliches Element (11), wobei das bewegliche Element (11) eine Membran (111) umfasst;
- einen als hinteres Volumen (12) bezeichneten inneren Hohlraum, der einem Referenzdruck ausgesetzt ist und durch das bewegliche Element (11) und eine erste und eine zweite Wand (101, 102), die zum Gestell (10) gehören, begrenzt wird, wobei die erste Wand (101) in der Verlängerung der Membran (111) liegt und die zweite Wand (102) gegenüber der Membran (111) angeordnet ist;
Verfahren, das die folgenden Schritte umfasst:
- Bereitstellen einer Schichtung (20), die nacheinander ein Substrat (21), eine erste Opferschicht (22) und eine erste Strukturschicht (23) umfasst, deren Dicke unter 2 µm beträgt;
- Ätzen der Strukturschicht (23) bis zur ersten Opferschicht (22), um die Membran (111) des beweglichen Elements (11) zu begrenzen;
- Übertragen (S10) einer Abdeckung (30) auf die erste Strukturschicht (23) und so das hintere Volumen (12) bilden; und
- Ätzen (S11) des Substrats (21), um auf die erste Opferschicht (22) zuzugreifen;
- Ätzen (S12) der ersten Opferschicht (22), um die Membran (111) freizusetzen;
**dadurch gekennzeichnet, dass** mindestens ein abgedichteter Hohlraum (103a) in einem Abschnitt (22a) der ersten Opferschicht (22) ausgebildet ist, so dass er sich in der ersten Wand (101) befindet, die das hintere Volumen (12) begrenzt, wobei der mindestens eine abgedichtete Hohlraum (103a) der ersten Wand (101) von dem hinteren Volumen (12) durch einen ersten Abschnitt (23a) der ersten Strukturschicht (23) und einen Druck getrennt ist, der niedriger als der Referenzdruck ist, der in dem mindestens einen abgedichteten Hohlraum (103a) der ersten Wand (101) herrscht.

8. Verfahren nach Anspruch 7, bei dem das Substrat (21) so geätzt wird, dass es einen Übertragungsarm (14) begrenzt, wobei das bewegliche Element (11) mit einem Ende des Übertragungsarms (14) gekoppelt ist und die erste Opferschicht (22) als Stoppschicht für das Ätzen des Substrats (21) dient.

9. Verfahren nach einem der Ansprüche 7 und 8, das nach dem Schritt des Bereitstellens der Schichtung (20) und vor dem Schritt (S10) des Übertragens der Abdeckung (30) außerdem die folgenden Schritte umfasst:
- Bilden (S6) einer zweiten Opferschicht (24) auf der ersten Strukturschicht (23);
- Bilden (S7) einer zweiten Strukturschicht (25) auf der ersten Strukturschicht (23) und der zweiten Opferschicht (24);
- Ätzen (S8) der zweiten Strukturschicht (25), um die zweite Opferschicht (24) freizusetzen und eine Versteifungsstruktur (112) der Membran (111) zu begrenzen;
- Ätzen (S9) der zweiten Opferschicht (24), um die Membran (111) freizusetzen.

10. Verfahren nach Anspruch 9, bei dem die erste Strukturschicht (23) und die zweite Strukturschicht (25) gleichzeitig geätzt werden, um die Membran (111) und die Versteifungsstruktur (112) des beweglichen Elements (11) zu begrenzen.

11. Verfahren nach einem der Ansprüche 7 bis 10, in dem die Bereitstellung der Schichtung (20) die folgenden Teilschritte umfasst:
- Ätzen (S1) der voneinander getrennten ersten und zweiten Hohlräume (210a, 210b) im Substrat (21);
- Bilden (S2) der ersten Opferschicht (22) auf dem Substrat (21), wobei die erste Opferschicht (22) einen ersten Abschnitt (22a), der in dem ersten Hohlraum (210a) angeordnet ist, und einen zweiten Abschnitt (22b), der in dem zweiten Hohlraum (210b) angeordnet ist, umfasst;
- Ätzen (S3) mindestens eines dritten Hohlraums (103a) im ersten Abschnitt (22a) der ersten Opferschicht (22);
- Übertragen (S4, S5) der ersten Strukturschicht (23) auf den ersten und zweiten Abschnitt (22a-22b) der ersten Opferschicht (22), um so den mindestens einen dritten Hohlraum (103a) abzudichten.

12. Verfahren nach einem der Ansprüche 7 bis 11, das außerdem einen Schritt zum Bereitstellen der Abdeckung (30) umfasst, der die folgenden Teilschritte umfasst:
- Ätzen (S21) von mindestens einem vierten Hohlraum (103b) in einem zusätzlichen Substrat (31);
- Übertragen (S22, S23) einer dritten Strukturschicht (32) auf das zusätzliche Substrat (31), um so den mindestens einen vierten Hohlraum (103b) abzudichten.

## Claims

1. Electroacoustic transducer (1) comprising:
- a frame (10) comprising a support (21), a first portion (23a) of a first structural layer (23) disposed on the support (21) and a cap (30) disposed on the first portion (23a) of the first structural layer (23), the first structural layer (23) having a thickness of less than 2 µm;
- a element (11) movable relative to the frame (10), the movable element (11) comprising a membrane (111);
- an internal cavity called back volume (12), subjected to a reference pressure and delimited by the mobile element (11) and first and second walls (101, 102) belonging to the frame (10), the first wall (101) being located as an extension of the membrane (111) and the second wall (102) being arranged facing the membrane (111);
**characterized in that** the first wall (101) comprises at least one sealed cavity (103a) separated from the back volume (12) by the first portion (23a) of the first structural layer (23) and in which a pressure lower than the reference pressure prevails in said at least one sealed cavity (103a) of the first wall (101).

2. Electroacoustic transducer (1) according to claim 1, wherein the pressure in said at least one sealed cavity (103a, 103b) is less than or equal to 1000 Pa, preferably less than or equal to 100 Pa.

3. Electroacoustic transducer (1) according to one of claims 1 and 2, wherein the membrane (111) is formed by a second portion (23b) of the first structural layer (23).

4. Electroacoustic transducer (1) according to any of claims 1 to 3, wherein the second wall (102) comprises at least one sealed cavity (103b), wherein a pressure lower than the reference pressure prevails in said at least one sealed cavity (103b) of the second wall (102) and wherein said at least one sealed cavity (103b) of the second wall (102) is located in the cap (30) and separated from the back volume (12) by a third structural layer (32) with a thickness of less than 2 µm.

5. Electroacoustic transducer (1) according to any of claims 1 to 4, wherein at least one of the first and second walls (101, 102) delimiting the back volume (12) comprises a single sealed cavity (103a, 103b), the single sealed cavity (103a, 103b) comprising pillars (104a, 104b) with a width of between 500 nm and 50 µm.

6. Electroacoustic transducer (1) according to any of claims 1 to 4, wherein at least one of the first and second walls (101, 102) delimiting the back volume comprises a plurality of sealed cavities (103a, 103b) separated from each other by partition walls having a width between 500 nm and 50 µm.

7. Method for manufacturing an electroacoustic transducer (1) comprising:
- a frame (10);
- a element (11) movable relative to the frame (10), the movable element (11) comprising a membrane (111);
- an internal cavity called back volume (12), subjected to a reference pressure and delimited by the mobile element (11) and first and second walls (101, 102) belonging to the frame (10), the first wall (101) being located as an extension of the membrane (111) and the second wall (102) being arranged facing the membrane (111);
method comprising the following steps of:
- providing a stack (20) successively comprising a substrate (21), a first sacrificial layer (22) and a first structural layer (23) having a thickness less than 2 µm;
- etching the first structural layer (23) down to the first sacrificial layer (22) so as to delimit the membrane (111) of the movable element (11);
- transferring (S10) a cap (30) onto the first structural layer (23), thus forming the back volume (12);
- etching (S11) the substrate (21) to access the first sacrificial layer (22);
- etching (S12) the first sacrificial layer (22) so as to release the membrane (111);
**characterized in that** at least one sealed cavity (103a) is formed in a portion (22a) of the first sacrificial layer (22), so as to be located in the first wall (101) delimiting the back volume (12), said at least one sealed cavity (103a) of the first wall (101) being separated from the back volume (12) by a first portion (23a) of the first structural layer (23) and a pressure lower than the reference pressure prevailing in said at least one sealed cavity (103a) of the first wall (101).

8. Method according to claim 7, wherein the substrate (21) is etched to delimit a transmission arm (14), the movable element (11) being coupled to one end of the transmission arm (14), the first sacrificial layer (22) serving as a stop layer in etching the substrate (21).

9. Method according to one of claims 7 and 8, further comprising, after the step of providing the stack (20) and before the step (S10) of transferring the cap (30), the following steps of:
- forming (S6) a second sacrificial layer (24) on the first structural layer (23);
- forming (S7) a second structural layer (25) on the first structural layer (23) and on the second sacrificial layer (24);
- etching (S8) the second structural layer (25) so as to expose the second sacrificial layer (24) and to delimit a structure for rigidifying (112) the membrane (111);
- etching (S9) the second sacrificial layer (24) so as to expose the membrane (111).

10. Method according to claim 9, wherein the first structural layer (23) and the second structural layer (25) are etched simultaneously so as to delimit the membrane (111) and the rigidifying structure (112) of the movable element (11).

11. Method according to any of claims 7 to 10, wherein the step of providing the stack (20) comprises the following substeps of:
- etching (S1) first and second disjointed cavities (210a, 210b) in the substrate (21);
- forming (S2) the first sacrificial layer (22) on the substrate (21), the first sacrificial layer (22) comprising a first portion (22a) disposed in the first cavity (210a) and a second portion (22b) disposed in the second cavity (210b);
- etching (S3) at least one third cavity (103a) in the first portion (22a) of the first sacrificial layer (22);
- transferring (S4, S5) the first structural layer (23) onto the first and second portions (22a-22b) of the first sacrificial layer (22), so as to seal said at least one third cavity (103a).

12. Method according to any of claims 7 to 11, further comprising a step of providing the cap (30) comprising the following substeps of:
- etching (S21) at least one fourth cavity (103b) in an additional substrate (31);
- transferring (S22, S23) a third structural layer (32) onto the additional substrate (31), so as to seal said at least one fourth cavity (103b).
